# EUROPEAN PATENT APPLICATION

(11) **EP 4 844 767 A1**
(43) Date of publication of application: **25.11.2026**
(21) Application number: 26180134.4
(22) Date of filing: 21.05.2026
(51) Int. Cl.: G11C 29/02, G11C 29/44, G11C 29/52, G11C 11/4074, G11C 29/50

(54) **ADAPTIVE UNCORRECTABLE ERROR CORRECTION CODE HIGH BANDWIDTH MEMORY MANAGEMENT FOR TENSOR PROCESSING UNIT SYSTEMS**

(30) Priority: 22.05.2025 US 202563810335 P
(71) Applicant: Google LLC, Mountain View, CA 94043 (US)
(72) Inventor: ONG, Tony, Mountain View, 94043 (US)
(74) Representative: Betten & Resch

(57) **Abstract**

A method for repairing HBM errors includes identifying a minimum voltage (Vmin) for a device housing the HBM, wherein the Vmin is determined at manufacture then identifying a maximum voltage (Vmax) for a device housing the HBM at manufacture. A nominal voltage (Vnom) falling between Vmin and Vmax is selected as operating voltage for the device. When a memory error is detected the Vnom is iteratively increased by a predetermined interval until the error is no longer detected. When the Vnom is achieved where the error is no longer detected, a new updated Vnom value for the device is set based on the voltage level that eliminates the memory error in the device. The iterative increasing of the Vnom can include increasing Vnom by an interval of 20 millivolts in each iteration. The performing the iteratively increasing of the Vnom may be done by a technician in the field.

## Description

### BACKGROUND

Graphic processing unit (GPU) and tensor processing unit (TPU) chips have high bandwidth memory (HBM) stackable memories. In the memory stack, power losses (IR losses) are experienced, particularly under heavy workloads such as machine learning (ML) operations. The challenges of these losses are well documented. The losses are commonly referred to as silent data corruption (SDC).

### SUMMARY

A method for repairing HBM errors includes identifying a minimum voltage (Vmin) for a device housing the HBM, wherein the Vmin is determined at manufacture then identifying a maximum voltage (Vmax) for a device housing the HBM at manufacture. A nominal voltage (Vnom) falling between Vmin and Vmax is selected as the operating voltage for the device. When a memory error is detected in the device the Vnom is iteratively increased by a predetermined interval until the error is no longer detected.

When the Vnom is achieved where the error is no longer detected, a new updated Vnom value for the device is set based on the voltage level observed to eliminate the memory error in the device. The iterative increasing of the Vnom can include increasing Vnom by a pre-determined interval in each iteration. By way of example, the pre-determined interval may be selected at 10 millivolts, or, by way of another example, the iterative increasing of the Vnom can include increasing Vnom by an interval of 20 millivolts in each iteration. The performing of the repair process by iteratively increasing of the Vnom may be done by a technician in the field.

The device housing the HBM can be a TPU installed a tray containing a number of TPUs. The selected Vnom may fall in a range from about 1.12 volts to about 1.24 volts for some HBM memory technologies. In other memory technologies the Vnom may span different voltage ranges between Vmin and Vmax. Vmin may fall within a tolerance range of up to about -2.5% of Vnom while Vmax can fall within a tolerance range of about +3% of Vnom. The HBM may include varying numbers of stacked layers. By way of non-limiting example, the stacked layers may include from about 8 layers to about 12 layers. As future designs are achieved, it may be expected that the number of stacked layers will exceed 12 layers. The nominal voltage of a tray may vary across a fleet of multiple trays to accommodate the Vnom required for error-free operation of HBM installed in each tray. When the device is manufactured, the Vmin and Vmax of the device is determined and an initial selection of Vnom for the device is selected to be relatively close to Vmin to allow for the iterative increasing of voltage during a repair process. Upon manufacture the determined Vmin and Vmax of the device can be stored in a non-volatile memory of the system.

According to an example method for repairing a device having HBM in the field begins by detecting an error in the HBM of the device and removing the device from operations. Beginning with operating the device at an initial nominal voltage (Vnom) the Vnom is iteratively increased until the error is no longer detected. The Vnom of the device is updated to the level at which the error is no longer detected. When operating at Vnom with no detected error, the device is returned to operation with the adjusted Vnom.

The device can be a TPU, the TPU housed in a tray housing a plurality of TPUs. During the repair process iteratively increasing the Vnom of the device can be performed by increasing the Vnom in 20 millivolt intervals. Vnom may fall in an operating voltage range from about 1.12 volts to about 1.24 volts. During manufacture, a minimum operating voltage (Vmin) and a maximum operating voltage (Vmax) of the device is determined and during the repair process iteratively increasing the Vnom falls within a range between Vmin and Vmax. Vmin and Vmax can be read from a non-volatile memory within the device stored at manufacture of the device.

### BRIEF DESCRIPTION OF THE DRAWINGS

FIG. 1 is a flow diagram illustrating the diagnosis and repair of a device with HBM according to aspects of the described technology.
FIG. 2 is a sectional view of a device with HBM according to aspects of the described technology.
FIG. 3 is a flow diagram for the repair of a device with HBM according to aspects of the described technology.
FIG. 4 is a process flow diagram for the diagnosis and repair of HBM errors according to aspects of the described technology.
FIG. 5 is a block diagram of a system where the diagnosis and repair of HBM can be performed according to aspects of the described technology.

### DETAILED DESCRIPTION

The technology is generally directed to the management of devices employing high bandwidth memory. Uncorrectable errors detected in a HBM are repaired by adjusting the nominal operating voltage of the memory. Methods for utilizing the technology can extend the useful life of devices with HBM and decrease the downtime for addressing uncorrectable errors in HBM.

High bandwidth memory is a type of computer memory that is designed to transfer data quickly while using less power. It is used in many computing devices including artificial intelligence (AI) accelerators, graphic cards, and data centers. HBM is made up of stacks of dynamic random access memory (DRAM) chips. The chips are stacked vertically using through silicon vias (TSVs) which are thin electrically conductive paths that interconnect layers. The three dimensional packaging design increases the density and bandwidth of the memory. HBM is often placed close to a processor to reduce latency and speed data transfer.

It has been observed that high failure rates and mean time before interruption (MTBI) occur in tensor processing units (TPU) using HBM. This hampers the ability to run training processes and serve machine learning (ML) jobs at large scale. One solution is to increase the HBM voltage to compensate for the internal IR drop. For example, the voltage may be raised from 1.12V to 1.24V in some TPU applications. It is observed that each 20 mV step increase in voltage results in improved HBM reliability at stress workloads. Operating at higher voltage produces two negative effects. First, higher HBM power dissipation occurs, which if the design hits the thermal limit the system results in throttling and the system performance degrades. Second, the long term reliability of the GPU/TPU chip will be negatively impacted. For instance. operating reliably expected for a span of 15 years will be drastically reduced to less than 10 years. Actual degradation needs to be carefully assessed through long term accelerated reliability tests. The HBM chip vendor also has specifications to ensure a particular voltage of operation should be maintained to guarantee the quality and life expectancy of the memory cells.

System manufacturing tests include setting a nominal HBM voltage. A margin up and down of -2.5 %, +3 % respectively occurs due to component variations and changes in operating conditions. For example, the system is tested up to 3%. This means the system will survive a voltage drift of up to 3% in the field under low workload utilization. Conversely, when the system is under heavy workload usage, the voltage can droop 2.5%. The problem arises because conventionally, nominal voltage across the fleet is fixed and cannot be adjusted in the field. Each time a high failure rate is experienced, a technician must increase the voltage, re-evaluate performance, thermal, power, system reliability and update the fleet with the new voltage.

All chips using high density, high bandwidth memory will experience this issue especially with configurations having 8-stacks or higher. Producers of GPUs, accelerators, and TPU chips all experience this issue as they use HBM memories. IEEE and HBM companies are releasing new memory controllers such as HBM3, HBM3e with error detection and correction. The controllers can only mitigate the failures by detection and error correction but cannot provide preventative measures.

Given the HBM spec and the actual IR drop may be ascertained through chip measurements. Manufacturing testing can step voltage between Vmin to Vmax for each tray design during manufacturing testing and record the resulting values of Vmin and Vmax in the tray design. When there is failure in the field, the voltage of the HBM can be raised by a predetermined increment through a repair process and if deemed successful, the machine is released back to the fleet. The downside with this technique is that not all trays in the system are operating at the same voltage. These fluctuations in voltage do not create an issue because not all TPU tray designs are designed equally. For example, due to complexity of board design and components, the tolerance stack-up can vary tremendously. For example, setting the nominal voltage to be X, will result in variations between X-2.5% to X+3% as an example. The repair process can automate this so no more manual intervention of multiple iterations to fine tune for best operating margins are necessary.

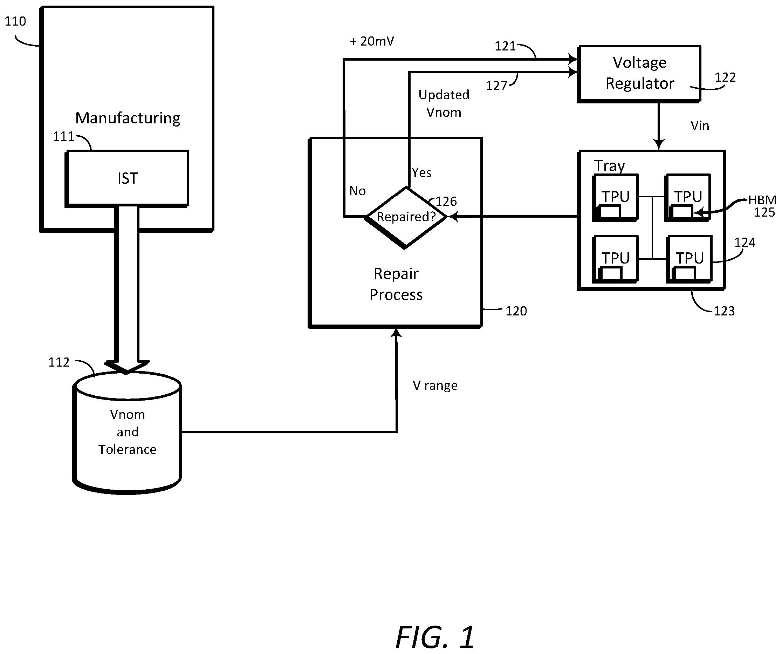

FIG. 1 is a flow diagram for a method of diagnosing and repairing errors in a device containing HBM according to aspects of the described technology. During a manufacturing process 110 the device is manufactured. Through integrated system testing (IST) 111, the device with HBM is tested under conditions of relatively higher voltage levels until the device experiences HBM errors. Similarly, IST 111 processes are performed at relatively lower voltage levels until the device experiences HBM errors. Based on the observation of the operating voltage range where the device operates without HBM errors, a nominal voltage, Vnom defines a voltage level for operating the device with the HBM under normal conditions. During manufacturing engineers in a lab may determine the Vnom for a small group of chips. Once the determined Vnom is observed to be reliable, the Vnom may be applied to a larger set of manufactured chips. In addition, based on the maximum and minimum voltage levels where the device operates absent HBM errors, a tolerance range is specified for allowable voltages where the device can be expected to operate reliably. The Vnom and tolerances are stored for the manufactured device 112. The Vnom and tolerances may be stored in an onboard memory of the device. In other cases, the Vnom and tolerances may be saved and made available to end users through a repository of product information provided by the original equipment manufacturer (OEM). The repository may be accessible through a distributed network including a local intranet or the Internet.

The voltage range is provided to a repair process 120. When a device, such as a TPU 124 which uses HBM 125 experiences memory errors, the appliance containing device 124 is sent to the repair process 120. The repair process iteratively tests the device to determine if the memory error is still present, the voltage applied to the HBM 125 is increased by an interval, such as an interval of 20 millivolts (mV) 121. A voltage regulator 122 for each device 124 is adjusted to raise the operating voltage of the device 124. The device is checked 126 to determine if the observed memory errors have been repaired. If the device is repaired, then the Vnom for the device is updated 127 to the first increased voltage level that does not experience the memory error.

If on the other hand, the memory errors are still present, then the voltage is again increased 121. This process is repeated each time the check 126 indicates the memory error still exits. If the voltage level is increased to a voltage level that exceeds the maximum voltage allowable by the device, then the device is irreparable and should be replaced.

The repair process 120 acts to incrementally increase the operating voltage of the device until a voltage level is reached that eliminates observed memory errors. Accordingly, when the Vnom is originally set at manufacture 110, it can be set as close as possible to the minimum voltage level in the tolerance range. In this way, if the repair process 120 is needed in the future, the repair process 120 will have a greater remaining range in which the voltage can be adjusted upward in 20 mV increments before exceeding the operating voltage range.

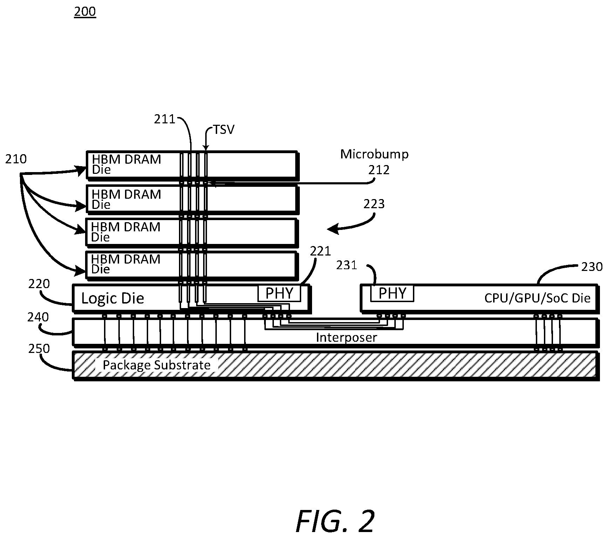

FIG. 2 is an illustration of a device 200 using high bandwidth memory according to aspects of the described technology. Device 200 processes information using a processor 230. Processor 230 can be a central processing unit (CPU), a graphics processing unit (GPU), a tensor processing unit (TPU), and the like. The processor 230 may be implemented in a system on chip (SoC) which includes circuit components comprising a processing system disposed on a single die.

Processor 230 includes a physical layer (PHY) 231 to establish data connections between the processor 230 hardware and the upper processing layers. PHY 231 of processor 230 is electrically connected via traces on an interposer 240 that connect PHY 231 of the processor 230 to PHY 221 of the HBM stack 223. Data is exchanged between HBM and the processor 230 via the connections established in the respective PHY 221, 231.

The HBM stack 223 includes a number of HBM dies 210 that contain the memory chips that store data. The HBM dies 210 are stacked vertically on top of each other, where adjacent layers are electrically connected via conductive through silicon vias (TSV) 211 and interconnecting conductive microbumps 212 disposed between die layers.

The stacked HBM dies 210 are in communication and controlled through a logic die 220 that includes the HBM stack 223 PHY 221. The logic die 220 may be placed on the interposer 240 layer which is supported by the package substrate 250. The stacked configuration 223 allows the placement of HBM dies 210 in close proximity to the processor 230 versus distributing the memory dies 210. This proximity reduces latency and allows for high speed processing provided by high bandwidth memory.

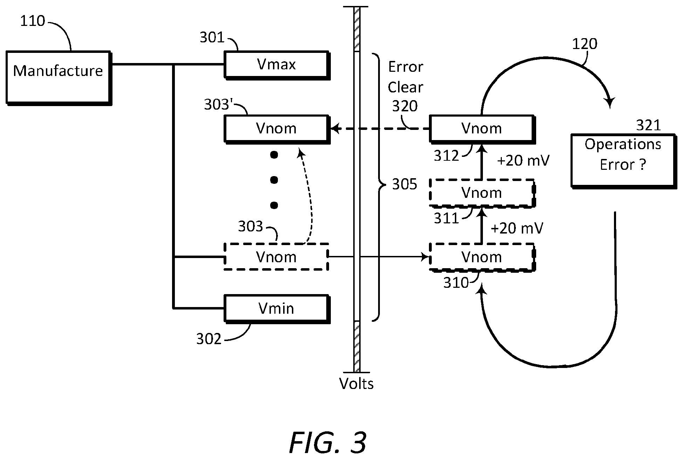

FIG. 3 is a block diagram showing the repair process 120 for repairing memory errors in devices using HBM according to aspects of the described technology. During manufacture 110 of a device having HBM, the device is tested and evaluated to determine the operating voltage range 305 for the device. Operating voltage range 305 defines a minimum voltage Vmin 302 and a maximum voltage Vmax 301. During manufacturing, it is determined through testing that operating at a voltage level higher than Vmax 301 or a voltage level lower than Vmin 302, the device will not operate properly. Within the operating voltage range 305, a nominal operating voltage Vnom 303 is selected that defines the recommended voltage level for operating the device. Initially, Vnom 303 is selected to be close to Vmin 302 to allow for adjustments to Vnom according to the repair process 120. Vnom 303 is selected to be sufficiently far above Vmin 302 such that the operating voltage tolerance of the device under stress will not cause the voltage level to fall below Vmin 302.

If a memory error is detected 321, the repair process is initiated 120. After removing the device from the production fleet, the repair process 120 increases the voltage applied to the device at intervals of 20 mV. At the start of the repair process 120, the initial voltage 310 is equal to the Vnom 303 originally determined at manufacture. The repair process then increases the Vnom by the prescribed interval to Vnom 311. At this point, the repair process will determine if the detected error 321 is still present. If the error persists, then the repair process 120 again increases the voltage by the prescribed interval to Vnom 312. Again, the repair process determines if the detected error 321 is still present. Assuming the error has cleared by raising the nominal voltage to Vnom 312, then the Vnom level attributed to the device 303' is updated 320 to the voltage level Vnom 312.

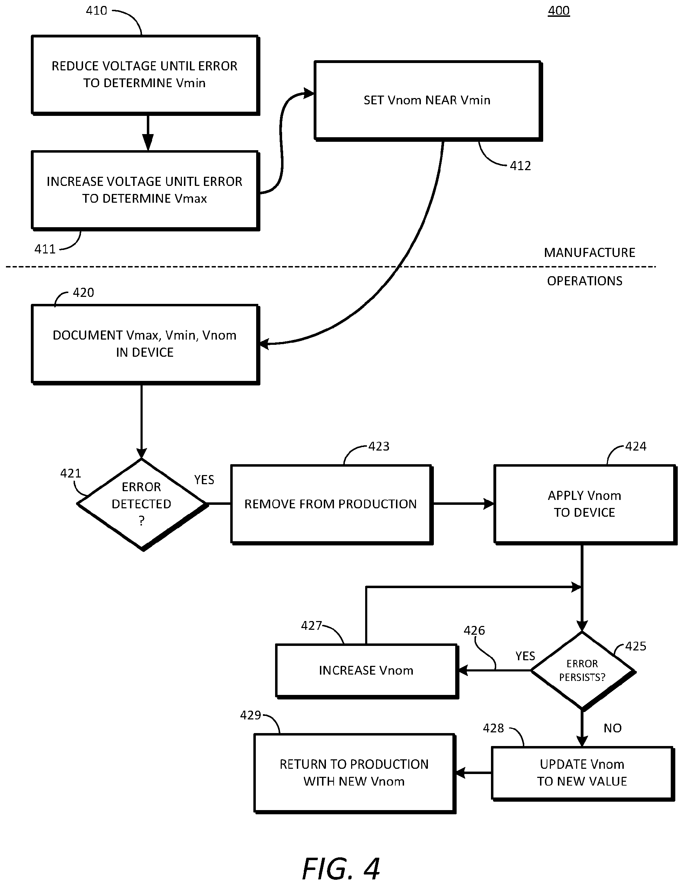

FIG. 4 is a process flow diagram of a method 400 for the diagnosis and repair of memory errors in a device using HBM according to aspects of the described technology. The repair process occurs to repair devices with HBM in operation. Some of the parameters used for the repair process are generated during the manufacture of the device. During manufacture, the device is tested at varying input voltage levels to determine the voltage levels at which the device is operational. The operating voltage is reduced to a point where the device begins to experience failures in order to determine the minimum voltage value Vmin at which the device can operate at block 410. Additionally, the voltage is raised to a voltage level at which the device begins to experience memory errors due to high voltage in order to determine the maximum operating voltage Vmax of the device at block 411. A nominal voltage Vnom is indicated as a voltage level at which the device will operate as designed. The value of Vnom will fall between the Vmin and Vmax determined for the device with Vnom being at a level where voltage fluctuation tolerances for the device for varying stress conditions will not fall below Vmin nor rise above Vmax. The Vnom will be placed closer to Vmin than to Vmax in order to allow the operating voltage of the device to be systematically increased during the repair process as indicated in block 412. The Vmin, Vmax and Vnom obtained during manufacture are then documented for the device, such as including those voltage levels in documentation, or storing them within a memory storage within the device at block 420.

During operations, when a device having HBM is observed to be experiencing memory errors 421, the device is isolated or removed from production at block 423. Beginning at the specified level of Vnom, the device is applied with the voltage level indicated by Vnom 424. It is then checked to determine if the memory errors still persist. 425. If the memory errors are still present, 426 the operating volage level is increased by a predetermined amount 427 and the device is operated at the new voltage level. At the new voltage level, the device is again checked to determine if the error persists 425. As long as the error persists 426, the operating voltage level will be iteratively increased until either the memory error is determined to be corrected, or the Vmax value of the device is exceeded.

If while checking to determine if the memory errors persist 425 and it is observed that the memory errors have been resolved, the most recently used operating voltage is used to update the device Vnom at block 428. The device can then be returned to production using the updated Vnom at block 429.

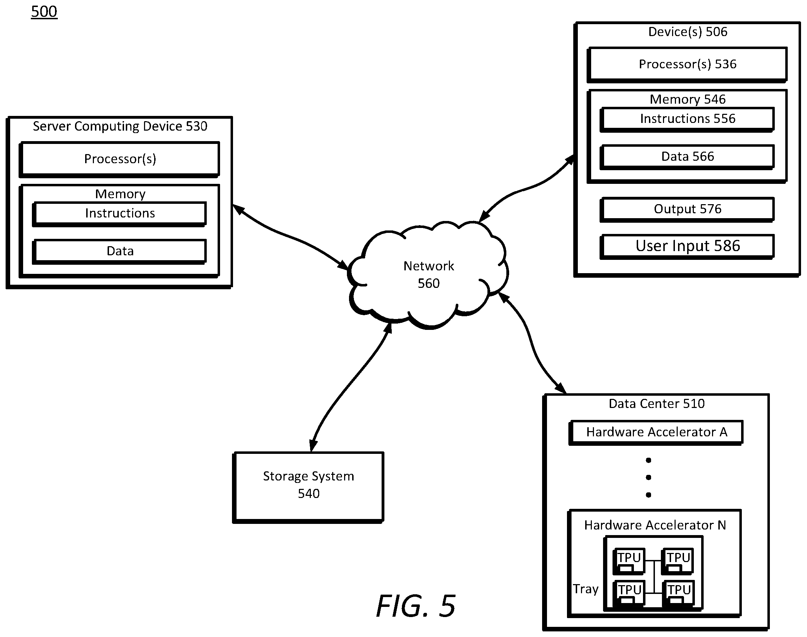

FIG. 5 is a block diagram of a network system that may implement a diagnostics and repair process for devices with HBM according to aspects of the described technology.

FIG. 5 illustrates an example system 500 in which the features described above may be implemented. It should not be considered limiting the scope of the disclosure or usefulness of the features described herein. In this example, system 500 may include device(s) 506, server computing device 530, storage system 540, and network 560.

Each device 506 may be a personal computing device intended for use by a respective user. The device 506 may include one or more processors 536, memory 546, data 566 and instructions 556. Each device 506 may also include an output 576, user input 586, and location sensor 596. By way of example only, devices 506 may be mobile phones or devices such as a wireless-enabled PDA, smartphones, a tablet PC, a wearable computing device (e.g., a smartwatch, AR/VR headset, smart helmet, etc.), a netbook that is capable of obtaining information via the Internet or other networks, or a smart home device, such as a home assistant, smart thermostat, smart doorbell, smart light, etc.

Memory 546 of device 506 may store information that is accessible by processor 536. Memory 546 may also include data that can be retrieved, manipulated or stored by the processor 536. The memory 546 may be of any non-transitory type capable of storing information accessible by the processor 536, including a non-transitory computer-readable medium, or other medium that stores data that may be read with the aid of an electronic device, such as a hard-drive, memory card, read-only memory ("ROM"), random access memory ("RAM"), optical disks, as well as other write-capable and read-only memories. Memory 546 may store information that is accessible by the processors 536, including instructions 556 that may be executed by processors 536, and data 566.

Data 566 may be retrieved, stored or modified by processors 536 in accordance with instructions 556. For instance, although the present disclosure is not limited by a particular data structure, the data 566 may be stored in computer registers, in a relational database as a table having a plurality of different fields and records, XML documents, or flat files. The data 566 may also be formatted in a computer-readable format such as, but not limited to, binary values, ASCII or Unicode. By further way of example only, the data 566 may comprise information sufficient to identify the relevant information, such as numbers, descriptive text, proprietary codes, pointers, references to data stored in other memories (including other network locations) or information that is used by a function to calculate the relevant data.

The instructions 556 can be any set of instructions to be executed directly, such as machine code, or indirectly, such as scripts, by the processor 536. In that regard, the terms "instructions," "application," "steps," and "programs" can be used interchangeably herein. The instructions can be stored in object code format for direct processing by the processor, or in any other computing device language including scripts or collections of independent source code modules that are interpreted on demand or compiled in advance. Functions, methods and routines of the instructions are explained in more detail below.

The one or more processors 536 may include any conventional processors, such as a commercially available CPU or microprocessor. Alternatively, the processor can be a dedicated component such as an ASIC or other hardware-based processors. Although not necessary, computing devices 506 may include specialized hardware components to perform specific computing functions faster or more efficiently.

Although FIG. 5 functionally illustrates the processor, memory, and other elements of devices 506 as being within the same respective blocks, it will be understood by those of ordinary skill in the art that the processor or memory may actually include multiple processors or memories that may or may not be stored within the same physical housing. Similarly, the memory may be a hard drive or other storage media located in a housing different from that of the devices 506. Accordingly, references to a processor or device will be understood to include references to a collection of processors, devices, or memories that may or may not operate in parallel.

Output 576 may be a display, such as a monitor having a screen, a touchscreen, a projector, or a television. The display 576 of the one or more computing devices 506 may electronically display information to a user via a graphical user interface ("GUI") or other types of user interfaces. For example, as will be discussed below, display 576 may electronically display query results.

The user input 586 may be a mouse, keyboard, touchscreen, microphone, or any other type of input.

The devices 506 can be at various nodes of a network 560 and capable of directly and indirectly communicating with other nodes of network 560. Although one device is depicted in FIG. 5, it should be appreciated that a typical system can include one or more devices, with each device being at a different node of network 560. The network 560 and intervening nodes described herein can be interconnected using various protocols and systems, such that the network can be part of the Internet, World Wide Web, specific intranets, wide area networks, or local networks. The network 560 can utilize standard communications protocols, such as WiFi, Bluetooth, 4G, 5G, etc., that are proprietary to one or more companies. Although certain advantages are obtained when information is transmitted or received as noted above, other aspects of the subject matter described herein are not limited to any particular manner of transmission.

In one example, system 500 may include one or more server computing devices 530 having a plurality of computing devices, e.g., a load balanced server farm, that exchange information with different nodes of a network for the purpose of receiving, processing and transmitting the data to and from other computing devices. For instance, one or more server computing devices 530 may be a web server that is capable of communicating with the one or more client computing devices 506 via the network 560. In addition, server computing device 530 may use network 560 to transmit and present information to a user of one of the other computing devices 506.

Server computing device 530 may include one or more processors, memory, instructions, data, etc. These components operate in the same or similar fashion as those described above with respect to computing device 506.

According to some examples, the server computing device 530 may be connected over the network to a data center 510 housing any number of hardware accelerators. Hardware accelerators can include devices that utilize high bandwidth memory. For example, hardware accelerator N in FIG. 5 includes a tray having a number of TPUs. Each TPU is equipped with HBM. When memory errors are detected in one or more of the TPUs, a process for diagnosis and repair of the HBM may be performed according to the technology described hereinabove. The data center 510 can be one of multiple data centers or other facilities in which various types of computing devices, such as hardware accelerators, are located. Computing resources housed in the data center can be specified for repeated results monitoring, including identifying repeated query results, or the like.

The server computing device 530 can be configured to receive queries from the client computing device 506 on computing resources in the data center 510. For example, the environment can be part of a computing platform configured to provide a variety of services to users, through various user interfaces and/or application programming interfaces (APIs) exposing the platform services. The variety of services can include identifying content responsive to the query, determining whether query results are repeated query results, or the like. The client computing device 506 can transmit input data associated with a query. The server computing device 530 can receive the input data and, in response, identify and provide for output query results. When identifying the query results, the server computing device 530 can generate a signature for the query results. The generated signature may be compared to other signatures associated with the query results and/or historical query signatures. Based on the comparison, the server computing device 530 can determine whether the query results are repeated query results. In examples where the query results are repeated query results, the server computing device 530 can enable one or more preventative measures.

As other examples of potential services provided by a platform implementing the environment, the server computing device can maintain a variety of models in accordance with different constraints available at the data center. For example, the server computing device can maintain different families for deploying models on various types of TPUs and/or GPUs housed in the data center or otherwise available for processing.

Aspects of this disclosure can be implemented in digital electronic circuitry, in tangibly embodied computer software or firmware, and/or in computer hardware, such as the structure disclosed herein, their structural equivalents, or combinations thereof. Aspects of this disclosure can further be implemented as one or more computer programs, such as one or more modules of computer program instructions encoded on a tangible non-transitory computer storage medium for execution by, or to control the operation of, one or more data processing apparatus. The computer storage medium can be a machine-readable storage device, a machine-readable storage substrate, a random or serial access memory device, or combinations thereof. The computer program instructions can be encoded on an artificially generated propagated signal, such as a machine-generated electrical, optical, or electromagnetic signal, which is generated to encode information for transmission to suitable receiver apparatus for execution by a data processing apparatus.

The term "configured" is used herein in connection with systems and computer program components. For a system of one or more computers to be configured to perform particular operations or actions means that the system has installed on its software, firmware, hardware, or a combination thereof that cause the system to perform the operations or actions. For one or more computer programs to be configured to perform particular operations or actions means that the one or more programs include instructions that, when executed by one or more data processing apparatus, cause the apparatus to perform the operations or actions.

The term "data processing apparatus" refers to data processing hardware and encompasses various apparatus, devices, and machines for processing data, including programmable processors, a computer, or combinations thereof. The data processing apparatus can include special purpose logic circuitry, such as a field programmable gate array (FPGA) or an application specific integrated circuit (ASIC). The data processing apparatus can include code that creates an execution environment for computer programs, such as code that constitutes processor firmware, a protocol stack, a database management system, an operating system, or combinations thereof.

The data processing apparatus can include special-purpose hardware accelerator units for implementing machine learning models to process common and compute-intensive parts of machine learning training or production, such as inference or workloads. Machine learning models can be implemented and deployed using one or more machine learning frameworks.

The term "computer program" refers to a program, software, a software application, an app, a module, a software module, a script, or code. The computer program can be written in any form of programming language, including compiled, interpreted, declarative, or procedural languages, or combinations thereof. The computer program can be deployed in any form, including as a stand-alone program or as a module, component, subroutine, or other unit suitable for use in a computing environment. The computer program can correspond to a file in a file system and can be stored in a portion of a file that holds other programs or data, such as one or more scripts stored in a markup language document, in a single file dedicated to the program in question, or in multiple coordinated files, such as files that store one or more modules, sub programs, or portions of code. The computer program can be executed on one computer or on multiple computers that are located at one site or distributed across multiple sites and interconnected by a data communication network.

The term "database" refers to any collection of data. The data can be unstructured or structured in any manner. The data can be stored on one or more storage devices in one or more locations. For example, an index database can include multiple collections of data, each of which may be organized and accessed differently.

The term "engine" refers to a software-based system, subsystem, or process that is programmed to perform one or more specific functions. The engine can be implemented as one or more software modules or components or can be installed on one or more computers in one or more locations. A particular engine can have one or more computers dedicated thereto, or multiple engines can be installed and running on the same computer or computers.

The processes and logic flows described herein can be performed by one or more computers executing one or more computer programs to perform functions by operating on input data and generating output data. The processes and logic flows can also be performed by special purpose logic circuitry, or by a combination of special purpose logic circuitry and one or more computers.

A computer or special purposes logic circuitry executing the one or more computer programs can include a central processing unit, including general or special purpose microprocessors, for performing or executing instructions and one or more memory devices for storing the instructions and data. The central processing unit can receive instructions and data from the one or more memory devices, such as read only memory, random access memory, or combinations thereof, and can perform or execute the instructions. The computer or special purpose logic circuitry can also include, or be operatively coupled to, one or more storage devices for storing data, such as magnetic, magneto optical disks, or optical disks, for receiving data from or transferring data to. The computer or special purpose logic circuitry can be embedded in another device, such as a mobile phone, a personal digital assistant (PDA), a mobile audio or video player, a game console, a Global Positioning System (GPS), or a portable storage device, e.g., a universal serial bus (USB) flash drive, as examples.

Computer readable media suitable for storing the one or more computer programs can include any form of volatile or non-volatile memory, media, or memory devices. Examples include semiconductor memory devices, e.g., EPROM, EEPROM, or flash memory devices, magnetic disks, e.g., internal hard disks or removable disks, magneto optical disks, CD-ROM disks, DVD-ROM disks, or combinations thereof.

Aspects of the disclosure can be implemented in a computing system that includes a back end component, e.g., as a data server, a middleware component, e.g., an application server, or a front end component, e.g., a client computer having a graphical user interface, a web browser, or an app, or any combination thereof. The components of the system can be interconnected by any form or medium of digital data communication, such as a communication network. Examples of communication networks include a local area network (LAN) and a wide area network (WAN), e.g., the Internet.

The computing system can include clients and servers. A client and server can be remote from each other and interact through a communication network. The relationship of client and server arises by virtue of the computer programs running on the respective computers and having a client-server relationship to each other. For example, a server can transmit data, e.g., an HTML page, to a client device, e.g., for purposes of displaying data to and receiving user input from a user interacting with the client device. Data generated at the client device, e.g., a result of the user interaction, can be received at the server from the client device.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description of the examples should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible implementations. Further, the same reference numbers in different drawings can identify the same or similar elements.

## Claims

1. A method for repairing high bandwidth memory (HBM) errors comprising:
identify a minimum voltage (Vmin) for a device housing the HBM, Vmin determined at manufacture;
identify a maximum voltage (Vmax) for a device housing the HBM, Vmax determined at manufacture;
determine a nominal voltage (Vnom) falling between Vmin and Vmax, and operating the device at Vnom; and
when a memory error is detected in the device, iteratively increasing the Vnom by a predetermined interval until the error is no longer detected.

2. The method of claim 1, further comprising:
setting a new Vnom value for the device based on the voltage level observed to eliminate the memory error in the device.

3. The method of claim 2, further comprising:
increasing Vnom by an interval of 20 millivolts in each iteration.

4. The method of claim 2 or claim 3, further comprising performing the iteratively increasing of the Vnom by a technician in the field.

5. The method of claim 4, wherein the device housing the HBM comprises a tensor processing unit (TPU).

6. The method of claim 5, wherein the device housing the HBM comprises a tray containing a plurality of TPUs.

7. The method of one of claims 1 to 6, wherein the Vnom is in a range from about 1.12 volts to about 1.24 volts.

8. The method of claim 6 or claim 7, wherein the Vmin is within a tolerance of -2.5% of Vnom; and/or
wherein the Vmax is within a tolerance of +3% of Vnom.

9. The method of one of claims 1 to 8, wherein the HBM comprises at least eight stacked layers; and/or
wherein nominal voltage of trays may vary across a fleet of multiple trays.

10. The method of one of claims 1 to 9, further comprising:
placing the device in operation with a Vnom that is close to Vmin; and/or further comprising:
storing the Vmin and Vmax for the device in a non-volatile memory of the device.

11. A method of repairing a device having high bandwidth memory (HBM) in the field comprising:
detecting an error in the HBM of the device;
removing the device from operations;
operating the device at a nominal voltage (Vnom);
iteratively increasing the Vnom until the error is no longer detected;
adjusting the Vnom of the device at the level where no error is detected; and
returning the device into operation with the adjusted Vnom.

12. The method of claim 11, wherein the device is a tensor processing unit (TPU); and/or wherein the device is a tray housing a plurality of tensor processing units (TPUs).

13. The method of claim 11 or claim 12, further comprising:
iteratively increasing the Vnom of the device in 20 millivolt intervals; and/or further comprising:
adjusting the Vnom to a value of about 1.12 volts to about 1.24 volts.

14. The method of one of claims 11 to 13, further comprising:
identifying a minimum operating voltage (Vmin) and a maximum operating voltage (Vmax) of the device; and
iteratively increasing the Vnom in a range between Vmin and Vmax.

15. The method of claim 14, further comprising:
reading the value of Vmin and Vmax from a non-volatile memory within the device.
